Europäisches Patentamt

European Patent Office

Office européen des brevets

(11) Veröffentlichungsnummer: **0 326 947**
**A1**

(12) **EUROPÄISCHE PATENTANMELDUNG**

(21) Anmeldenummer: 89101357.5

(22) Anmeldetag: 26.01.89

(51) Int. Cl.⁴: **H03K 19/094**

(30) Priorität: 05.02.88 DE 3803544

(43) Veröffentlichungstag der Anmeldung:
09.08.89 Patentblatt 89/32

(84) Benannte Vertragsstaaten:
DE FR GB

(71) Anmelder: **Siemens Aktiengesellschaft Berlin
und München
Wittelsbacherplatz 2
D-8000 München 2(DE)**

(72) Erfinder: **Heimsch, Wolfgang, Dr.
Romanstrasse 30
D-8000 München 19(DE)**
Erfinder: **Müllner, Ernst, Dipl.-Ing.
Erzgiessereistrasse 21
D-8000 München 2(DE)**

(54) **Asymmetrischer Differenzverstärker als Pegelwandler.**

(57) Asymetrischer Differenzverstärker als Pegelwandler mit zwei Transistoren (TR1, TR2), einer
Konstantstromquelle (SQ) und zwei Widerständen
(W1, W2), bei dem der erste Transistor (TR1) ein
MOS-Transistor und der zweite Transistor (TR2) ein
bipolarer npn-Transistor ist. Auf der Eingangsseite
des Differenzverstärkers können an dem Eingang (E)
Eingangssignale mit CMOS-Pegel angelegt werden,
während an dem Ausgang (A, $\overline{A}$) Ausgangssignale
mit ECL-Pegel abgriffen werden können. Neben der
Aufgabe als Differenzierverstärker erbringt die Schaltung ebenfalls eine Pegelumwandlung zwischen
CMOS-Pegel auf der Eingangsseite und ECL-Pegel
auf der Ausgangsseite.

FIG 1

EP 0 326 947 A1

## Asymmetrischer Differenzverstärker als Pegelwandler

Die Erfindung betrifft einen asymmetrischen Differenzverstärker als Pegelwandler nach dem Oberbegriff des Patentanspruchs 1.

Ein Differenzverstärker ist ein symmetrischer Gleichspannungsverstärker mit zwei Eingängen und zwei Ausgängen. Er wird in den meisten Fällen mit Hilfe von zwei Transistoren aufgebaut, wobei jeweils ein Anschluß beider Transistoren mit einer Konstantstromquelle verbunden ist. Die Konstantstromquelle bewirkt, daß die Summe der Ströme durch beiden Transistoren konstant bleibt. Legt man eine unterschiedlich hohe Spannung an beiden Eingängen des Differenzverstärkers an, so ändert sich die Stromaufteilung im Differenzverstärker. Der Strom durch den einen Transistor nimmt dabei zu, während der Strom durch den anderen Transistor abnimmt. Die Summe der beiden Stromstärken ist jedoch gleich der Stromstärke, die von der Konstantstromquelle geliefert wird. Eine Eingangsspannungsdifferenz ruft bei einem Differenzverstärker eine Ausgangsspannungsänderung hervor. Eine temperaturbedingte Änderung der Spannungen an den Transistoren wirkt wie eine Gleichtaktaussteuerung und bleibt wirkungslos. Deshalb verwendet man den Differenzverstärker bevorzugt auch als Gleichspannungsverstärker.

Aus der Literatur sind schon seit längerem Grundschaltungen für den Differenzverstärker bekannt. Aus dem Buch "Halbleiter-Schaltungstechnik" von Tietze-Schenk in der fünften überarbeiteten Auflage ist auf Seite 59 die Grundschaltung eines Differenzverstärkers angegeben, und auf den nachfolgenden Seiten 59 bis 64 ist der Aufbau und die Wirkungsweise des aus npn-Bipolar-Transistoren bestehenden Differenzverstärkers aufgezeigt. Im Gegensatz dazu ist auf Seite 89 auf Abbildung 5.14 in der gleichen Literaturstelle eine Grundschaltung eines Feldeffektdifferenzverstärkers angegeben, wobei dieser mit Hilfe von zwei n-Kanal-Sperrschicht-Feldeffekttransistoren Nh 1 Sti/01.02.1988 realisiert ist.

Durch die Anwendung von Feldeffekttransistoren lassen sich gegenüber der Schaltung in Abbildung 4.32 wesentlich bessere Ergebnisse bezüglich des Eingangsstroms, der Bandbreite und des Rauschens erzielen. Weitere Angaben zum Feldeffektdifferenzverstärker sind auf den Seiten 90 bis 92 in der genannten Literaturstelle wiederzufinden.

Die Realisierung eines Differenzverstärkers entweder mit Bipolartransistoren oder mit Feldeffekttransistoren bedingt jeweils die Vorteile bzw. die Nachteile, die für die jeweilige Transistorform entscheidend ist. Die Realisierung eines Differenzverstärkers mit Hilfe von Bipolartransistoren bzw. in ECL-Technik bedingt den Nachteil, daß die Transistoren gegeneinander zu isolieren sind. Sehr geringe logische Ausgangspegel als Ergebnis von geringen Ladungsbewegungen erbringen für einen Differenzverstärker in dieser Technik eine relativ hohe Verarbeitungsgeschwindigkeit. Die logischen Ausgangspegel liegen üblicherweise im Bereich von 0 bis 200 Millivolt. Bei der Realisierung eines Differenzverstärkers von Feldeffekttransistoren, beispielsweise mit Hilfe der CMOS-Technik, ergeben sich relativ hohe logische Ausgangspegel, jedoch ist eine solche Schaltung langsamer gegenüber einem Differenzverstärker, der mit Hilfe von Bipolartransistoren aufgebaut ist. Mit Hilfe der CMOS-Schaltungstechnik ist eine relativ hohe Packungsdichte der einzelnen Transistoren möglich. Logische Ausgangspegel liegen hier zwischen 0 und 5 Volt.

Der Erfindung liegt die Aufgabe zugrunde, einen Differenzverstärker vorzustellen, der mit Hilfe einer gemischten ECL-/CMOS-Schaltungstechnik realisiert werden kann.

Diese Aufgabe wird durch die kennzeichnenden Merkmale des Patentanspruchs 1 gelöst.

Die mit der Erfindung erzielten Vorteile bestehen insbesondere darin, daß der asymmetrische Differenzverstärker durch die gemischte ECL-/CMOS-Schaltungstechnik an seinen beiden Ausgängen Ausgangshübe im Millivoltbereich abgibt, die ECL-Pegeln entsprechen und andererseits an einem ersten Eingang CMOS-Pegel zwischen 0 und 5 Volt verarbeiten kann. Interne Pegelschwankungen, die an dem gemeinsamen Verbindungspunkt zwischen der Konstantstromquelle und den beiden Transistoren durch Schalten des CMOS-Transistors auftreten und die die Verarbeitungsgeschwindigkeit des Differenzverstärkers reduzieren, werden durch Einbau des bipolaren npn-Transistors verringert. Die Hübe werden durch die Höhe des Stroms mit der Stromquelle eingestellt und die Ausgangspegel an den beiden Ausgängen des Differenzverstärkers sind unabhängig von den Streuungen der Kenngrößen des CMOS-Transistors, dies wird durch eine geeignete Wahl einer Referenzspannung am zweiten Eingang des Differenzverstärkers sichergestellt.

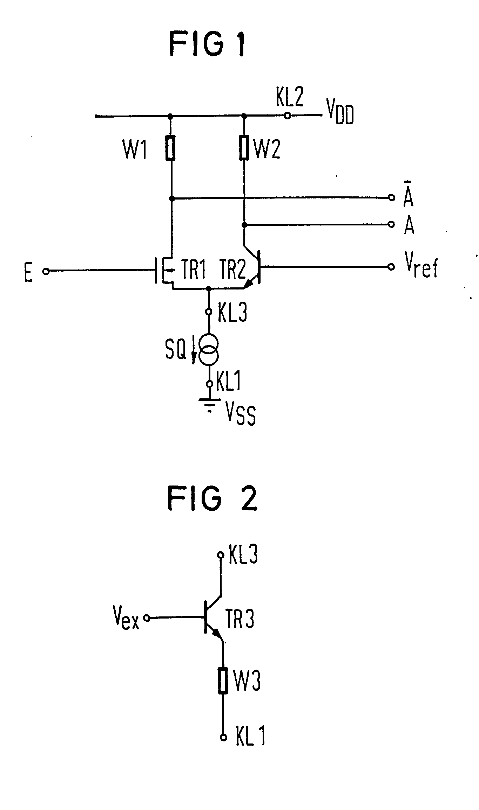

Ein Ausführungsbeispiel der Erfindung ist in der Zeichnung Fig. 1 dargestellt und wird im folgenden näher beschrieben. Es zeigt:

Fig. 1 einen Differenzverstärker in gemischter ECL-/CMOS-Schaltungstechnik,

Fig. 2 eine Realisierung einer Konstantstromquelle für den Differenzverstärker.

Der in Fig. 1 dargestellte asymmetrische Differenzverstärker enthält einen ersten n-Kanal-MOS-Transistor TR1 und einen zweiten npn-Bipolar-Transistor TR1, eine Konstantstromquelle SQ sowie einen ersten und zweiten Widerstand W1, W2. Der Widerstandswert des ersten und zweiten Widerstandes W1, W2 kann beispielsweise mit 200 Ohm dimensioniert werden und der Strom durch die Konstantstromquelle SQ soll 1 mA betragen. In diesem Falle beträgt der Stromfluß durch einen der beiden Widerstände 1 mA und erzeugt einen Spannungsabfall von 200 mV, welcher ausreichend für einen ECL-Hub ist. Ein erster Anschluß des n-Kanal-MOS-Transistors TR1 und der Emitteranschluß des npn-Bipolar-Transistors TR2 sind gemeinsam über die Konstantstrom quelle SQ, die zwischen beiden Klemmen KL1 und KL3 geschaltet ist, mit der Masse $V_{SS}$ verbunden. Die zweite Anschluß des n-Kanal-MOS-Transistors TR1 ist über den ersten Widerstand W1 auf die Klemme KL2 geschaltet und der Kollektorausgang des npn-Bipolar-Transistors TR2 ist über den zweiten Widerstand W2 ebenfalls mit der Klemme KL2 verbunden. An dem Differenzverstärker nach Fig. 1 ist weiterhin die Klemme KL2 mit der Versorgungsspannung $V_{DD}$ beschaltet. Der erste Eingang E, an dem CMOS-Eingangssignale angelegt werden, ist mit dem Gateanschluß des n-Kanal-MOS-Transistors TR1 verschaltet, während der zweite Eingang $V_{ref}$, auf dem ein Referenzsignal aufgeschaltet wird, ist mit dem Basisanschluß des npn-Bipolartransistors TR2 verbunden. Das Referenzsignal für den Referenzeingang $V_{ref}$ liegt innerhalb des Low- und High-Pegels des CMOS-Eingangssignals. Ein erster Ausgang $\overline{A}$ des Differenzverstärkers liefert ein invertiertes Ausgangssignal und ist an dem zweiten Anschluß des n-Kanal-MOS-Transistors TR1 angeschlossen, während der zweite Ausgang A ein nicht invertiertes Ausgangssignal liefert und mit dem Kollektoranschluß des npn-Bipolartransistors TR2 verbunden ist.

In dem Differenzverstärker nach Fig. 1 ist für den ersten Transistor TR 1 ein n-Kanal-MOS-Transistor vorgesehen, ebenfalls ist es jedoch möglich, hierfür einen p-Kanal-MOS-Transistor zu verwenden. In diesem Falle ist der erste und zweite Ausgang $\overline{A}$, A miteinander zu vertauschen.

Die Schaltung nach Fig. 1 erbringt eine Pegelanpassung zwischen CMOS-Pegel auf der Eingangsseite und ECL-Pegel auf der Ausgangsseite. Logische "High"- bzw. "Low"-Pegel zwischen 5 bzw. 0 Volt werden demnach auf den Eingang E geschaltet, während an den Ausgängen A bzw. $\overline{A}$ Ausgangshübe im Millivoltbereich, beispielsweise zwischen 0 und einigen 100 mV abgegriffen werden können. Dies ermöglicht ein direktes Anschließen von Schaltungen in ECL-Technik, die eine höhere Verarbeitungsgeschwindigkeit gegenüber CMOS-Schaltungen besitzen. Die asymmetrische Differenzverstärkerschaltung nach Fig. 1 eignet sich besonders gut zum Einbau in Addierzellen, bei dem ECL-Schaltungen für eine besonders schnelle Verarbeitung von Carrysignalen sorgen.

Fig. 2 zeigt eine mögliche Realisierung für die Konstantstromquelle SQ, die zwischen den Klemmen KL3 und KL1 geschaltet ist. Die Konstantstromquelle enthält hierbei einen weiteren bipolaren npn-Transistor TR3, an dessen Basisanschluß eine feste Spannung $V_{ex}$ angeschlossen ist, wobei diese feste Spannung $V_{ex}$ die Stromgröße für die asymmetrische Differenzverstärkerschaltung nach Fig. 1 bestimmt. Zwischen dem Emitteranschluß des weiteren bipolaren npn-Transistors TR3 und der Klemme KL1 ist ein Widerstand W3 geschaltet, dessen Widerstandswert ungefähr 500 Ohm betragen soll. Durch die Verschaltung des Widerstandes W3 ergibt sich eine Stromgegenkopplung, die zu einem stabilen Konstantstrom führt. Daher sollte der Widerstand W3 nicht zu klein gewählt werden.

Die Konstantstromquelle nach Fig. 2 zeigt lediglich eine von mehreren Möglichkeiten einer Konstantstromquelle für den Differenzierverstärker nach Fig. 1. Weitere Möglichkeiten zur Realisierung einer solchen Konstantstromquelle sind beispielsweise in der technischen Literatur "Halbleiterschaltungstechnik" von Tietze-Schenk, 5. Auflage, S. 53 bis 56 und auf Seite 87 zu entnehmen.

## Ansprüche

1. Asymmetrischer Differenzverstärker mit einem ersten und einem zweiten Transistor (TR1, TR2), einer Konstantstromquelle (SQ) und einem ersten und zweiten Widerstand (W1, W2), wobei ein erster Anschluß des ersten Transistors (TR1) und ein erster Anschluß des zweiten Transistors (TR2) gemeinsam über die Konstantstromquelle (SQ) mit einer ersten Klemme (KL1) und ein zweiter Anschluß des ersten Transistors (TR1) über den ersten Widerstand (W1) und ein zweiter Anschluß des zweiten Transistors (TR2) über den zweiten Widerstand (W2) mit einer zweiten Klemme (KL2) verbunden ist, ein erster Eingang (E) mit einem Steueranschluß des ersten Transistors (TR1), ein zweiter Eingang ($V_{ref}$) mit einem Steueranschluß des zweiten Transistors (TR2) angeschlossen ist und ein erster Ausgang ($\overline{A}$) mit einem zweiten Anschluß des ersten Transistors (TR1) und ein zweiter Ausgang (A) mit dem zweiten Anschluß des zweiten Transistors (TR2) verschaltet ist, **dadurch gekennzeichnet,** daß der erste Transistor (TR1) ein MOS-Transistor und der zweite Transistor (TR2) ein bipolarer Transistor ist, daß auf den ersten Eingang Eingangssignale für den MOS-Transistor und auf den zweiten Eingang ein Referenzsignal, welches zwischen einem Maximum und Minimum der Eingangssignale für den MOS-Transistor liegt, aufgeschaltet ist.

2. Asymmetrischer Differenzverstärker nach Anspruch 1, **dadurch gekennzeichnet,** daß der erste Transistor (TR1) ein n-Kanal-MOS-Transistor und der zweite Transistor (TR2) ein npn-Bipolar-Transistor ist.

3. Asymmetrischer Differenzverstärker nach Anspruch 1, **dadurch gekennzeichnet,** daß der erste Transistor (TR1) ein p-Kanal-MOS-Transistor und der zweite Transistor (TR2) ein npn-Bipolar-Transistor ist und der erste und zweite Ausgang (A, $\overline{A}$) miteinander vertauscht sind.

4. Asymmetrischer Differenzverstärker nach einem der Ansprüche 1 bis 3, **dadurch gekennzeichnet,** daß die Konstantstromquelle (SQ) einen weiteren bipolaren npn-Transistor (TR3) enthält, daß ein Basisanschluß des weiteren npn-Transistors (TR3) mit einer festen Spannung ($V_{ex}$) und ein Emitteranschluß des weiteren bipolaren npn-Transistors (TR3) über einen dritten Widerstand (W3) mit der ersten Klemme (KL1) und ein Kollektoranschluß des weiteren bipolaren npn-Transistors (TR3) mit dem ersten Anschluß des ersten Transistors (TR1) und mit dem ersten Anschluß des zweiten Transistors (TR2) verschaltet ist.

5. Asymmetrischer Differenzverstärker nach einem der Ansprüche 1 bis 3, **dadurch gekennzeichnet,** daß die Konstantstromquelle (SQ) ein n-Kanal-MOS-Transistor ist, daß ein erster Anschluß des n-Kanal-MOS-Transistors mit der ersten Klemme (KL1), ein zweiter Anschluß des n-Kanal-MOS-Transistors mit dem ersten Anschluß des ersten Transistors (TR1) und mit dem ersten Anschluß des zweiten Transistors (TR2) verschaltet ist, daß ein Gateanschluß des n-Kanal-MOS-Transistors mit einer festen Spannung beschaltet ist.

6. Asymmetrischer Differenzverstärker nach einem der Ansprüche 1 bis 5, **dadurch gekennzeichnet,** daß die erste Klemme (KL1) mit Masse ($V_{SS}$) und die zweite Klemme (KL2) mit der Versorgungsspannung ($V_{DD}$) verschaltet ist.

# FIG 1

# FIG 2

| | Europäisches Patentamt | EUROPÄISCHER RECHERCHENBERICHT | Nummer der Anmeldung |
|---|---|---|---|

EP 89 10 1357

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 645 951 (URAGAMI) * Figuren 6,9; Spalte 7, Zeile 34 - Spalte 8, Zeile 37; Spalte 9, Zeile 56 - Spalte 10, Zeile 42 * ----- | | H 03 K 19/094 |

RECHERCHIERTE SACHGEBIETE (Int. Cl.4)

H 03 K

Der vorliegende Recherchenbericht wurde für alle Patentansprüche erstellt

| Recherchenort | Abschlußdatum der Recherche | Prüfer |
|---|---|---|
| DEN HAAG | 11-05-1989 | FEUER F.S. |

EPO FORM 1503 03.82 (P0403)